# DEMANDE DE BREVET EUROPEEN

(11) **EP 0 593 329 A1**
(43) Date de publication de la demande: **20.04.1994**
(21) Numéro de dépôt: 93402404.3
(22) Date de dépôt: 01.10.1993
(51) Int. Cl.: H01L 41/26, H01L 37/02

(54) **Procédé d'amélioration de la polarisation rémanente d'une couche en matériau polymère, et applications à des transducteurs pyroélectriques et piézoélectriques**

(30) Priorité: 12.10.1992 FR 9212140
(71) Demandeur: THOMSON-CSF, 75008 Paris (FR)
(72) Inventeur: Servet, Bernard, F-92402 Courbevoie Cedex (FR); Ries, Simone, F-92402 Courbevoie Cedex (FR); Alnot, Patrick, F-92402 Courbevoie Cedex (FR); Facoetti, Hugues, F-92402 Courbevoie Cedex (FR); Robin, Philippe, F-92402 Courbevoie Cedex (FR); Wittmann, Jean-Claude, F-92402 Courbevoie Cedex (FR)
(74) Mandataire: Guérin, Michel

(57) **Abrégé**

Ce procédé d'amélioration de la polarisation rémanente d'une couche en matériau polymère comporte les étapes suivantes :
- réalisation, à la surface d'un substrat (1), d'un réseau (2) de dimensions microniques ou submicroniques ;
- dépôt d'une couche de polymère (3) ;
- recuit (fusion) à une température de recuit légèrement supérieure à la température de fusion du polymère pendant un temps dépendant de cette température de recuit ;
- trempe à une température avoisinant la température de recristallisation du polymère et de préférence très légèrement à cette température de recristallisation ;
- application d'un champ électrique par polarisation de la couche de polymère (3).

L'invention est applicable à la réalisation de transducteurs pyroélectriques et de transducteurs piézoélectriques.

## Description

L'invention concerne un procédé d'amélioration de la polarisation d'une couche en matériau polymère et applications à des transducteurs et notamment à des transducteurs pyroélectriques et des transducteurs piézoélectriques.

Certains polymères, tels que le polyfluorure de vinylidène, et des copolymères qui lui sont dérivés possèdent des caractéristiques particulières de piézoélectricité et de pyroélectricité.

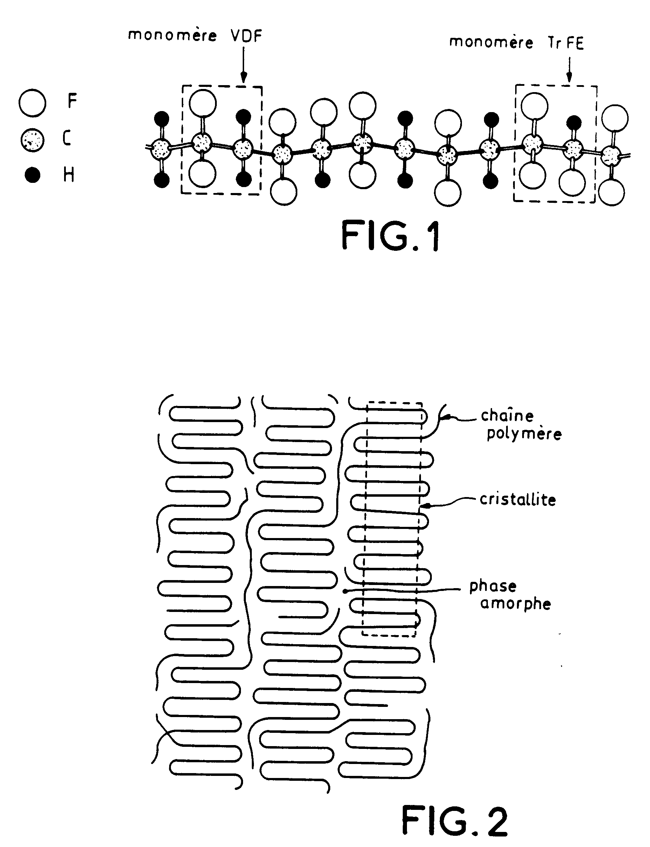

Par exemple le copolymère de fluorure de vinylidène et de trifluoroéthylène P(VD-TrFE) possède une structure moléculaire telle que représentée en figure 1. Il possède à température ambiante une phase ferroélectrique et, à haute température (supérieure à la température de Curie), une phase paraélectrique. On s'aperçoit donc déjà que la détection du passage de la phase ferroélectrique à la phase paraélectrique permet de réaliser un détecteur pyroélectrique.

Par ailleurs, les polymères linéaires (tel que le PVDF-TrFE) produisent lors de la cristallisation une organisation cristalline telle qu'il y ait un repliement des chaînes tel que représenté en figure 2.

Entre les chaînes cristallisées subsistent des chaînes désordonnées qui constituent la phase amorphe ayant une caractéristique élastomère. On assiste donc à la formation de domaines cristallins dispersés dans une matrice amorphe. Une couche de polymère orientée et polarisée voit sa polarisation varier sous l'effet d'un effort mécanique exercé selon l'axe de polarisation. Un effet piézoélectrique trouve son origine dans la phase cristalline ferroélectrique et on constate que la structure cristalline enrobée dans une structure amorphe produit un effet d'amplification de l'effet piézoélectrique.

Pour l'effet pyroélectrique comme pour l'effet piézoélectrique, la polarisation est importante.

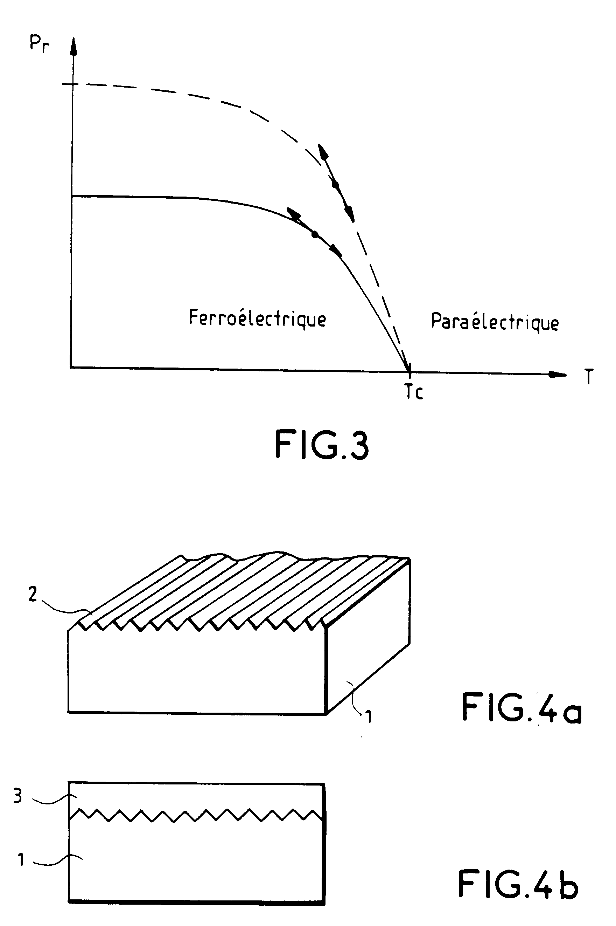

La figure 3 représente la variation de la polarisation rémanente Pr d'un matériau polymère ferroélectrique en fonction de la température T. A l'intérieur de la courbe, le matériau est ferroélectrique et à l'extérieur de la courbe le matériau est paraélectrique. Pour obtenir une bonne détection en température, il faut donc se situer sur une partie de la courbe présentant une pente importante au point de détection. Ce qui veut dire que pour un matériau déterminé ayant donc une température de Curie Tc déterminée, on a intérêt à avoir une polarisation rémanente maximale (voir courbe en pointillés de la figure 3). Cela est obtenu en ayant un matériau polarisé de manière homogène. Cette polarisation peut découler d'une organisation cristalline du polymère.

En ce qui concerne l'effet piézoélectrique, la polarisation a son importance comme on l'a déjà vu.

L'invention fournit une solution permettant d'imposer à une couche de polymère une orientation cristalline en vue d'obtenir une polarisation rémanente maximale du matériau. De plus, l'invention permet également d'augmenter la résistivité de la couche polymère.

L'invention concerne donc un procédé d'amélioration de la polarisation rémanente d'une couche d'un matériau polymère semi-cristallin, caractérisé en ce qu'il comporte les étapes suivantes :
- réalisation à la surface d'un substrat d'un réseau de dimensions microniques ou submicroniques ;
- dépôt de la couche de matériau polymère ;
- recuit (fusion) de cette couche à une température de recuit supérieure à la température de fusion ;
- trempe de cette couche par refroidissement à une température de trempe voisine de la température de cristallisation ;
- application d'un champ électrique à la structure pour imposer une polarisation rémanente.

Dans ce procédé, la température de recuit liée à la durée du recuit ainsi que la température de trempe ont une grande importance de façon à obtenir une couche polymère ayant une polarisation et une résistivité optimales.

Selon une autre caractéristique de l'invention, le réseau est réalisé par frottement de la surface du substrat à l'aide d'un élément en polytetrafluoroethylène.

L'invention est applicable à la réalisation de transducteurs piézoélectriques et pyroélectriques. On prévoit alors la réalisation d'une première électrode à la surface du substrat avant la réalisation du réseau ainsi qu'une deuxième électrode après le traitement de la couche de polymère.
les différents objets et caractéristiques de l'invention apparaîtront plus clairement dans la description qui va suivre et dans les figures annexées qui représentent :
- les figures 1 à 3, des illustrations de fonctionnements de polymères connus dans la technique ;
- les figures 4a à 4d, des étapes du procédé selon l'invention ;
- la figure 5, un exemple de réalisation d'un transducteur piézoélectrique ou pyroélectrique selon l'invention.

En se reportant aux figures 4a, 4b on va donc maintenant décrire un procédé de réalisation selon l'invention.

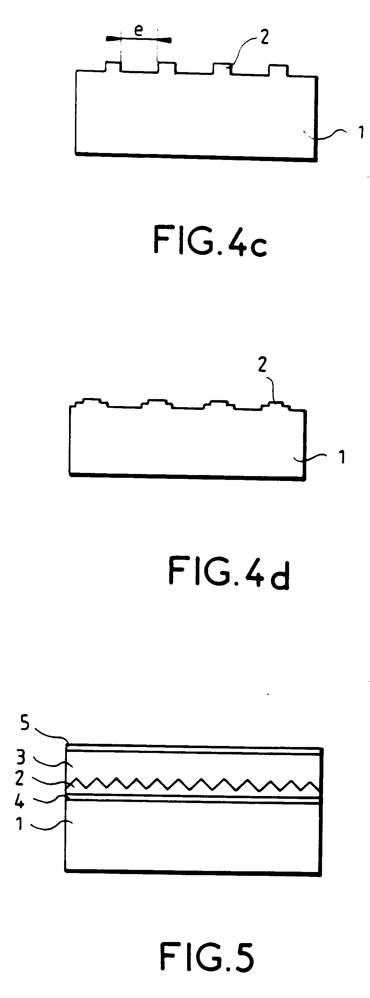

A la surface d'un substrat 1, on réalise une structure de réseau 2 de dimensions microniques ou submicroniques. Ce réseau peut être un réseau de stries tel que représenté en figure 4a, ou une surface continue comportant un réseau de marches tel que representé en figures 4c ou 4d, ou une combinaison des deux types de réseaux. L'espace entre deux marches pourra être de l'ordre de quelques centaines de nanomètres (300 à 500 nm par exemple). Puis sur cette structure on réalise une couche 3 d'un matériau polymère. On obtient la structure de la figure 4b sur laquelle le réseau 2 a été représenté pour simplifier sous la forme d'un réseau de stries. De cette façon, les chaînes moléculaires telles que celles de la figure 1 ont tendance à s'aligner dans les stries du réseau 2. On impose ainsi un ordre cristallin. Pour figer cet ordre cristallin on effectue tout d'abord une fusion qu'on appellera dans ce qui suit un recuit du matériau polymère. Ce recuit se fait à une température légèrement supérieure à la température de fusion. Puis on effectue une opération de trempe à une température avoisinant la température de cristallisation du matériau polymère. L'orientation des molécules de polymère est donc ainsi imposée par le réseau 2.

Pour être plus précis, le réseau 2 est réalisé sur une surface d'un substrat (tel que par exemple un semiconducteur amorphe) qui peut être de plusieurs centimètres carrés, en frottant cette surface avec un élément en PTFE (polytetrafluoroethylène) de façon à effectuer des dépôts continus de PTFE et qui réalisent ainsi le réseau 2. Cette opération est faite à une température située entre 130°C et 300°C en exerçant une pression d'environ 1 Kg/cm² et à une vitesse de déplacement de frottement par exemple de 1 mm/sec.La couche de PTFE peut avoir une épaisseur de quelques nanomètres.

La couche de matériau polymère 3 est déposée selon un procédé tel que celui de la tournette avec une épaisseur de quelques micromètres par exemple (10 µm).

Pour le dépôt à la tournette le polymère contient un solvant. De manière connue, on laisse donc le solvant s'évaporer. Ensuite on procède à un recuit en portant l'ensemble à une température supérieure à la température de fusion du polymère d'au maximum 40°C par rapport à la température de fusion.

Ce recuit s'effectue par exemple pendant quelques secondes à quelques dizaines de secondes. Plus précisément, le polymère est chauffé à une température T peu supérieure à son point de fusion, pendant un laps de temps t suffisant pour que la fusion soit complète (T^{∼}160°C et t = quelques secondes pour le polymère utilisé tel que le PVDF-TrFE), t sera d'autant plus réduit que T est élevée.

Ensuite on refroidit rapidement (on effectue une trempe) à une température avoisinant la température de cristallisation du polymère. Plus précisément, on choisira une température de trempe juste au-dessous de la température de cristallisation rapide, de quelques degrés par exemple (voire 1 ou 2 degrés) au-dessous de la température de cristallisation. Par exemple dans le cas du PVDF-TrFE on choisira une température d'environ 125°C. On constate par ce procédé, qu'on obtient une organisation cristalline régulière de la couche polymère et on élimine le problème de mouillage du PTFE. On obtient de plus, une forte résistivité. Les températures de recuit et de trempe choisies dans les gammes de températures indiquées ci-dessus sont importantes dans le cadre de l'invention pour obtenir ces résultats.

Ce traitement permet donc d'induire une croissance orientée du polymère par pseudo-épitaxie à partir du réseau 2 qui fait croître les fibrilles de polymère d'une marche à l'autre (ou d'une strie à l'autre) avec les axes C du copolymère couchés parallèlement au plan du substrat et parallèlement au grand axe des marches. On obtient une bonne uniformité du film qui lui confère une forte résistivité électrique intrinsèque.

La couche 3 est ensuite soumise à un champ électrique et est ainsi orientée électriquement pour donner une polarisation rémanente au matériau et pour obtenir des coefficients pyroélectriques et piézoélectriques maximaux.

Le procédé décrit est applicable à la réalisation de transducteurs pyroélectriques ou piézoélectriques.

Pour cela avant de réaliser le réseau (la couche de PTFE), on fabrique à la surface du substrat une ou plusieurs électrodes 4 (figure 5). Cette électrode est de préférence métallique, voire transparente (ITO).

De même après les étapes de récuit et de trempe de la couche 3 de polymère, on réalise une électrode supérieure 5 qui peut être également transparente.

En fonctionnement comme piézoélectrique, des contraintes mécaniques sont détectées par détection des variations de polarisations.

En fonctionnement comme pyroélectrique, ce dispositif peut être utilisé pour détecter des rayonnements tels que des rayonnements infra-rouge. L'électrode 4 et le substrat 1, ou l'électrode 5 doivent être alors transparents au rayonnement à détecter.

L'invention permet donc d'améliorer les performances de l'imageur pyroélectrique en termes de sensibilité et de résolution thermique. Une amélioration de 20 % de la polarisation rémanente permet d'améliorer de 20 % la résolution thermique de l'imageur.

Dans une forme de réalisation d'un détecteur infra-rouge, un circuit de lecture à transfert de charges CCD est combiné à un détecteur pyroélectrique.

Pour cela le circuit de lecture a été préalablement réalisé suivant les techniques habituelles connues de l'homme de l'art. Sur sa partie supérieure, il porte un jeu d'électrodes qui détermine un réseau de points détecteurs. A la tournette, on dépose par-dessus une couche de polyimide de 10 µm d'épaisseur. Cette couche sert d'isolant thermique. Un recuit à 300-400°C est alors nécessaire pour obtenir une complète imidisation du polyimide. Une étape de gravure permet de dégager des trous à l'aplomb des plots conducteurs. Ces trous sont ensuite métallisés (évaporation d'un métal sous-vide) afin de les rendre conducteurs. Sur la surface de la couche polyimide sont réalisés des électrodes élémentaires connectées chacune à une métallisation. Ces électrodes correspondent à l'électrode 4 de la figure 5 précédemment décrite.

Une couche de PTFE est maintenant déposée par friction sur le circuit préalablement chauffée à une température voisine de 300°C. La couche de polymère pyroélectrique est alors déposée par la méthode de la tournette. Une étape de recuit peut être effectuée pour évaporer le solvant sous vide.

Le circuit est ensuite traité thermiquement comme cela a été décrit précédemment. C'est-à-dire on réalise un circuit puis une trempe pour recristalliser la couche avec une orientation cristalline et une résistivité élevées. Une seconde électrode (correspondant à l'électrode 5 de la figure 5) est alors déposée sur le polymère, par évaporation sous-vide pour appliquer le champ électrique et induire la polarisation rémanente maximale.

Une couche d'absorbant I.R. (destinée à absorber le rayonnement optique à détecter et à transmettre la chaleur reçue au polymère) est enfin déposée sur l'électrode 5. Le détecteur est alors prêt à fonctionner.

## Revendications

1. Procédé d'amélioration de la polarisation rémanente d'une couche d'un matériau polymère semi-cristallin, caractérisé en ce qu'il comporte les étapes suivantes :
- réalisation à la surface d'un substrat (1) d'un réseau de dimensions microniques ou submicroniques (2) espacées selon un pas voisinant la dimension d'un atome ;
- dépôt de la couche de matériau polymère (3) ;
- recuit (fusion) de cette couche à une température de recuit supérieure à la température de fusion ;
- trempe de cette couche par refroidissement à une température de trempe voisine de la température de cristallisation ;
- application d'un champ électrique à la structure pour imposer une polarisation rémanente.

2. Procédé selon la revendication 1, caractérisé en ce que la réalisation du réseau (2) est faite sous la forme d'une couche monoorientée de PTFE (Polytetrafluoroethylène).

3. Procédé selon la revendication 2, caractérisé en ce que la couche monoorientée de PTFE est réalisée par frottement de la surface d'un substrat à l'aide d'un élément en PTFE.

4. Procédé selon la revendication 1, caractérisé en ce que le réseau (2) est un réseau de marches ou un réseau de stries.

5. Procédé selon la revendication 1, caractérisé en ce que le matériau polymère est un copolymère.

6. Procédé selon l'une des revendications 3 ou 5, caractérisé en ce que le copolymère est un copolymère de fluorure de vinylidène et de trifluoroéthylène (P(VDF-TrFE).

7. Procédé selon la revendication 6, caractérisé en ce que le copolymère possède une composition de 70 à 80 % de fluorure de vinylidène et de 30 à 20 % de trifluoroéthylène.

8. Procédé selon la revendication 7, caractérisé en ce que le polymère possède une composition de sensiblement 75 % de fluorure de vinylidène et de 25 % de trifluoroéthylène.

9. Procédé selon l'une des revendications 1 ou 8, caractérisé en ce que la température de recuit est sensiblement supérieure d'au maximum 40°C par rapport à la température de fusion.

10. Procédé selon la revendication 8, caractérisé en ce que la température de recuit est sensiblement supérieure d'au maximum 20°C par rapport à la température de fusion et que le temps de recuit est de quelques secondes à environ une dizaine de secondes.

11. Procédé selon la revendication 1, caractérisé en ce que la température de trempe est voisine de la température de cristallisation ou voisine de cette température de cristallisation.

12. Procédé selon la revendication 1, caractérisé en ce que la température de trempe est inférieure de quelques degrés par rapport à la température de cristallisation.

13. Procédé selon la revendication 12, caractérisé en ce que la température de trempe est inférieure de 1 à 2 degrés par rapport à la température de cristallisation.

14. Procédé selon la revendication 1, caractérisé en ce que la durée du recuit est de quelques secondes à quelques dizaines de secondes.

15. Application du procédé selon l'une quelconque des revendications précédentes, à la réalisation d'un transducteur piézoélectrique ou pyroélectrique, caractérisé en ce qu'avant la réalisation du réseau (2), on réalise une première électrode (4) et en ce qu'après l'étape de la trempe on réalise une deuxième électrode (5) sur la couche de polymère (3).

16. Application du procédé selon la revendication 14, caractérisé en ce que le substrat est un matériau semiconducteur.

17. Transducteur piézoélectrique ou pyroélectrique appliquant le procédé selon la revendication 15, caractérisé en ce qu'il comporte :
- des éléments en matériau semiconducteur situés dans un même plan, ces éléments appartenant aux électrodes d'accès d'un ou plusieurs dispositifs à transfert de charges ;
- une couche de polytetrafluoroéthylène (PTFE) monoorientée recouvrant ces éléments ;
- une couche de matériau polymère semi-cristallin recouvrant la couche de polytetrafluoroéthylène, possédant une structure cristalline régulière et polarisée ;
- au moins une électrode supérieure disposée sur la couche de matériau polymère.
